# EUROPEAN PATENT APPLICATION

(11) **EP 0 668 608 A1**
(43) Date of publication of application: **23.08.1995**
(21) Application number: 95300811.7
(22) Date of filing: 09.02.1995
(51) Int. Cl.: H01L 21/00

(54) **Electrostatic chuck with erosion-resistant electrode connection**

(30) Priority: 22.02.1994 US 199916
(71) Applicant: APPLIED MATERIALS, INC., Santa Clara California 95054-3299 (US)
(72) Inventor: Shamouilian, Shamouil, San Jose, CA 95120 (US); Birang, Manoocher, Los Gatos, CA 95036 (US); Goldspiel, Alan, Watsonville, CA 95076 (US); Northup, Ron, San Jose, CA 95124 (US); Somekh, Sasson, Los Altos Hills, CA 94022 (US)
(74) Representative: Bayliss, Geoffrey Cyril

(57) **Abstract**

An electrostatic chuck (32) is provided for firmly holding a semiconductor substrate (8) in position in a processing chamber (10). The electric connection (46) for the electrode (34) of the electrostatic chuck is provided through an aperture (44) in the pedestal (30) to protect the strap portion (40) of the chuck from erosion caused by the processing environment.

## Description

The present invention is directed to the field of holding and positioning semiconductor substrates within processing chambers during substrate processing operations. More particularly, the present invention is directed to improvements in the structure of electrostatic chucks used to hold and position semiconductor substrates in processing chambers.

Electrostatic chucks are used in semiconductor processing chambers to hold individual semiconductor substrates on a chamber structural member, such as a pedestal. An electrostatic chuck typically includes at least a dielectric layer and an electrode, which may be located on a chamber pedestal or formed as an integral part of the chamber pedestal. A semiconductor substrate is placed in contact with the dielectric layer, and a direct current voltage is placed on the electrode to create the electrostatic attractive force to grip the substrate on the chuck. An electrostatic chuck is particularly useful in vacuum processing environments where the maximum differential pressure which can be established between the low pressure chamber and the face of the chuck is insufficient to firmly grip the substrate on the chuck, or where mechanical clamping of the substrate to the chuck is undesirable.

Although an electrostatic chuck may be formed from as little as a single dielectric layer and an electrode, one more typical working configuration is a thin laminate member which is supported on a chamber pedestal to receive and support the substrate. The laminate member preferably includes an electrode core, preferably a thin copper member, which is sandwiched between upper and lower dielectric layers of an organic material such as polyimide. An adhesive such as polyamide may be used to attach the polyimide layers to the electrode core. The lower dielectric layer of the laminate member is attached directly to the upper surface of the chamber pedestal, usually with an adhesive such as polyamide, and the upper dielectric layer forms a planar surface on which the substrate is received. To prevent exposure of the electrode to the chamber environment, the upper and lower dielectric layers and adhesive layers extend beyond the edges of the electrode core, and are interconnected at that location to form a dielectric barrier between the electrode core and the chamber environment. To supply the high voltage potential to the electrode, a strap, formed as an integral extension of the laminate member, extends around the edge of the pedestal and connects to a high voltage connector on the underside of the pedestal.

The use of organic materials as the dielectric layer of the electrostatic chuck creates an inherent limitation in the useful life of the chuck, as organic materials, including polyimides, have relatively low tolerance for many process gases and plasmas, particularly to oxygen and oxygen-based plasmas. Although the majority of the surface area of the dielectric portions of the dielectric chuck are protected from the plasma by the substrate, the dielectric material is exposed to the chamber plasma along the surface of the conductive strap where it extends over the edge of the pedestal and along the edge of the electrostatic chuck below the substrate. Over numerous process and clean cycles, the plasma will eventually erode the dielectric areas to the point where arcing occurs between the electrode and plasma, which destroys the effectiveness of the chuck. In oxide etch chambers, where CHF₃ or CF₄ are used as the plasma gas and the dielectric material is an organic material such as polyimide, minimal erosion of the organic dielectric layer is attributable to the process plasma. However, the oxygen plasma used to clean the chamber of carbon and fluorine containing polymer contaminant is a major contributor to the erosion of the organic dielectric layer and the ultimate exposure of the electrode core to the plasma. This exposure occurs after approximately every thousand process and clean cycles where a thin polyimide material is used as the dielectric layer of the chuck. Dielectric materials other than those particularly mentioned above may also be adversely affected by exposure to process and cleaning gases and plasmas. For example, dielectrics such as Quartz and SiO₂ are eroded by CHF₃ and CF₄ plasma environments. Likewise, chuck configurations other than those using a laminate member construction may be adversely affected by process and cleaning gasses and plasmas, such that the dielectric layers thereof will be eroded to the point where an arc will form between the electrode and the plasma.

The present invention is an electrostatic chuck for use in semiconductor processing chambers in which the high voltage connection, which connects the electrode of the electrostatic chuck to the high voltage power source, may be directed through the mass of the pedestal. The high voltage connection is made underneath the area of the pedestal on which the substrate is received, rather than over the edge of the pedestal. Placement of the high voltage connection through the mass of the pedestal decreases the area of the electrostatic laminate which is exposed to the plasma, by eliminating the strap portion of the electrostatic laminate which extends over the edge of the pedestal.

The following is a description of some specific embodiments of the invention, reference being made to the accompanying drawings, in which
Figure 1 is a simplified view of a plasma etch chamber including an electrostatic chick therein shown in section;
Figure 2 is a plan view of an electrostatic chuck and pedestal;
Figure 3 is a sectional view of the electrostatic chuck of Figure 2 at Section 3-3 received on a pedestal and cathode;
Figure 4 is an enlarged partial sectional view of the electrostatic chuck and pedestal of Figure 3 at Section 4-4, further including a substrate thereon;
Figure 5 is a partial sectional view of the electrostatic chuck and pedestal of Figure 2 at section 5-5 received over a cathode, showing the interconnection of the high voltage power source to the electrostatic laminate;
Figure 6 is a bottom view of the electrostatic chuck and pedestal of Figure 2; and
Figure 7 is a sectional view of an alternative embodiment of the electrostatic chuck of the present invention located on a chamber pedestal.

In accordance with the present invention, an electrostatic chuck is provided with means for reducing the rate of erosion of the dielectric, or insulative, portions thereof which are exposed to plasma or gas and therefore increase the number of process and clean cycles which may be performed with the electrostatic chuck before the chuck electrode is exposed to the plasma. In the preferred embodiment, the electrostatic chuck is described for use in an oxide plasma etch chamber wherein oxygen-based cleaning plasma is the primary contributor to the erosion of the dielectric portions of the chuck, and the structure of the chuck includes a thin laminate member 32 which includes an electrically conductive core disposed between layers of dielectric material. However, the present invention may be used with other substrate processes such as CVD, PVD, metal etch, silicon oxide, poly silicon, w-etch and silicon etch, among others, and with other electrostatic chuck configurations, without deviating from the scope of the invention.

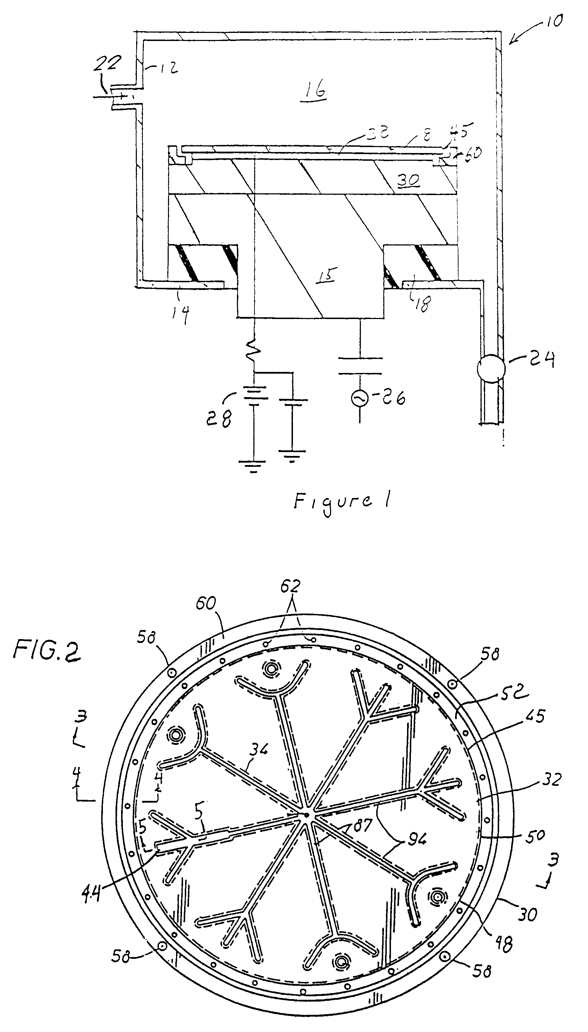

Referring to Figure 1, a simplified sectional schematic view of an etch chamber 10 is shown. The chamber 10 includes an outer housing 12 received over a base 14, which forms an enclosure 16 for the plasma etch process. During processing, this enclosure 16 is evacuated and maintained at a predetermined, sub-atmospheric, pressure. The housing 12 includes a gas inlet 22 for introduction of plasma forming gas species into the enclosure 16, and the base 14 includes a throttled exhaust 24 therein to exhaust the reacted plasma and gas products from the enclosure 16. A cathode 15, which includes a conductive pedestal 30 as a top layer thereof, is received over an aperture in the base 14, and an insulator flange 18 is disposed between the base 14 and the cathode 15 to electrically isolate the cathode 15 from the housing 12 and the base 14. In the preferred embodiment, the electrostatic chuck is configured as a laminate member 32 mounted on the pedestal 30, and the pedestal 30 with the laminate member 32 adhered thereto is bolted onto the cathode 15. The laminate member 32 includes an electrically isolated conductive portion therein which is energized with a high voltage source for electrostatically chucking a substrate 8 to the chuck. An RF source 26 is coupled to the cathode 15, which when energized establishes an RF electric field between the cathode 15 and the grounded enclosure walls to convert the gas introduced into the evacuated enclosure 16 into a plasma. A high voltage power source 28 is provided to energize the laminate member 32 to create the electrostatic attractive force to grip a substrate 8 to the laminate member 32.

To process substrates in the chamber 10, a substrate 8 is placed into the evacuated chamber 10 through a slit valve (not shown) and placed on the upper surface of the electrostatic laminate member 32. A process gas is then introduced through the enclosure inlet 22, and the RF source 26 is energized to convert the gas into a plasma for etching of the substrate 8. Alternatively, a cleaning gas such as oxygen is introduced into the enclosure 16 and energized into a cleaning plasma for cleaning of the chamber 10. During the etching and cleaning cycle, the high voltage source 28 energizes the conductive portion of the laminate member 32 to electrostatically hold the substrate 8 to the laminate member 32. When the etching or cleaning cycle is complete, the RF source 26 is de-energized and the gas is exhausted from the chamber.

In a preferred embodiment of the invention, a masking gas is provided to protect the exposed dielectric portions of the chuck from the process gas and plasma. During process or clean cycles, the substrate 8 located on the laminate member 32 blocks access of the process gas and plasma to the majority of the surface area of the dielectric portions of the laminate member 32. However, the perimeter 45 of the laminate member 32, and the dielectric materials along that perimeter 45, are exposed to the chamber environment during both clean and etch cycles. The masking gas is introduced into the area adjacent the perimeter 45 to block access of the process gas and plasma to the perimeter 45. To enhance the protective effect of the masking gas, a circumferential channel 60 may be provided about the perimeter 45 of the laminate member 32 and spaced therefrom to form a gas directing and retaining gap therebetween. During process or clean cycles in chamber 10, the masking gas, preferably a non-reactive species such as argon or helium, is introduced into the gap to reduce the concentration of the reactive plasma species adjacent the laminate perimeter 45. As a result, the rate of erosion of the dielectric material along the laminate perimeter 45 is significantly reduced, which increases the useful life of the laminate member 32.

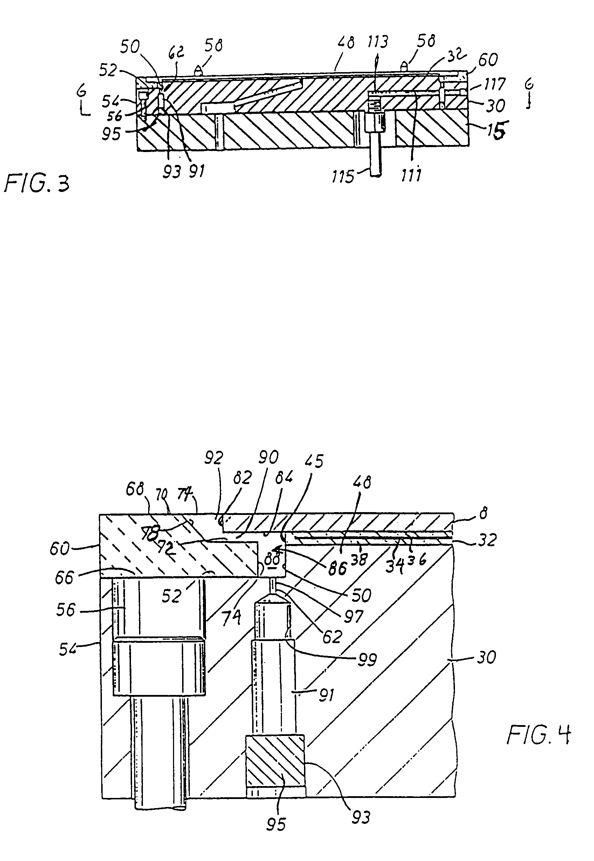

Referring now to Figures 2, 3 and 4, the preferred configuration of the pedestal 30, laminate 32 and masking gas channel 60 which are used to form the gap in which the masking gas is maintained are shown. The pedestal 30 is a generally right circular member having a central raised portion which forms a circular laminate member receiving portion 48, and an outwardly extending annular collar ledge 52 which is a reduced height portion of the pedestal 30 extending circumferentially around the raised laminate receiving portion 48 and configured to receive the channel 60 thereon. The inner radial boundary of the collar ledge 52 terminates in a circumferential wall or face 50 extending upwardly from the collar ledge 52 and terminating at the outer edge of the raised laminate receiving portion 48. The laminate member 32 is attached to the laminate receiving portion 48, such that the circumferential outer perimeter 45 of the laminate member 32 aligns with the intersection of the circumferential face 50 and the raised laminate receiving portion 48 as best shown in Figure 4. The ledge 52 also includes a plurality of counter-bored holes 56 therethrough (shown in Figures 3 and 4), which receive bolts therein to attach pedestal 30 to cathode 15, and a plurality of DC pickup pins 58 extend upwardly therefrom and into the enclosure 16. The pickup pins 58 form a conductive path for plasma generation within enclosure 16 (shown in Figures 2 and 3).

Referring now to Figure 2, the laminate member 32 includes a central, generally planar electrode 34, which is preferably copper, sandwiched between an upper layer 36 and a lower layer 38 of dielectric material, which are preferably a polyimide or other organic material. The upper and lower dielectric layers 36, 38 are preferably adhered to electrode 34 with an adhesive layer of epoxy such as polyamide. In the preferred embodiment, the laminate member 32 is a circular member having a plurality of radial slots 87 therethrough (best shown in Figure 2). These slots may be provided with a gas, such as helium, to cool the substrate 8 during etching. To insulate the electrode 34 along its outer edge, the dielectric layers 36, 38 extend past the edges of the electrode 34 to form an outer circular perimeter 45. These extending portions of the dielectric layers 36, 38 are connected together, preferably by an extension of the adhesive layer which connects the electrode 32 to the layers 36, 38. This interconnection of the dielectric layers 36, 38 forms a protective barrier at the slots 87, the laminate perimeter 45, and all other apertures through laminate member 32.

Referring now to Figure 4, the details of the masking gas protective system for directing masking gas over the exposed outside edge surfaces of the electrostatic chuck, particularly the exposed perimeter 45 of the dielectric layers, is shown. Preferably, the masking gases used in conjunction with the masking gas protective system are non-reactive gases, such as argon or helium, but the masking gas may also include some fraction of other gases, including reactive gases, and still provide substantial benefit. The masking gas protective system preferably includes the collar 60 located on the collar ledge 52 of the pedestal 30 which, in conjunction with a plurality of gas injection holes 62 in the collar ledge 52, provides a continuous flow of non-reactive gas, such as argon or helium, about the perimeter 45 of laminate member 32 during plasma etch and/or chamber cleaning operations.

The collar 60 is preferably a right annular member configured to direct and maintain the masking gas in contact with the dielectric portions of the chuck. The collar 60 includes an annular base 66 configured to be received on the collar ledge 52 of the pedestal 30, and a contoured top 68. The top 68 includes an upper outer annular face 70, an inner annular face 72 located a portion of the full height of the collar 60 from the base 66, and an annular frusto-conical face 78 extending between the outer annular face 70 and the inner annular face 72. The collar 60 also includes an inner circular face 74 extending between the base 66 and inner annular face 72 thereof. The collar 60 may be formed from quartz, ceramic or other materials which can withstand the chamber environment with minimal erosion and particle generation.

The arrangement of the masking gas protective system, particularly the collar 60, pedestal 30, laminate member 32 and their relationship with a substrate 8 held on the laminate member 32, effectively defines a circumferential gas manifold functioning to insure that an even, circumferentially continuous barrier curtain of protective masking gas is directed at, and maintained continually in place about, the perimeter of the dielectric layer of the laminate member 32, in particular about perimeter 45. Although the collar 60 and the pedestal 30 provide sufficient structure to direct a portion of the masking gas exiting the gas injection holes 62 adjacent the edge 45 of the laminate member 32 to mask the perimeter 45 thereof, in the preferred embodiment of the invention the substrate 8 cooperates with the pedestal 30 and the channel 60 to provide the gas manifold. As shown in Figure 4, the substrate 8, which is received on the laminate member 32, is slightly larger than the laminate 32 and the laminate receiving portion 48 of the pedestal 30. Therefore, the outer circular edge 82 and a portion 84 of the underside of the substrate 8 extend outwardly from the laminate member 32. The overhanging portion 84 of the substrate overhangs, but does not block the gas flow from, the gas injection holes 62. Thus the gas injection holes 62, collar 60, circumferential wall 50, laminate perimeter 45, substrate overhanging portion 84 and edge 82 together can be considered as defining the preferred gas manifold arrangement 86. The preferred structure of the manifold arrangement 86 preferably provides a series of circumferential gaps formed between the individual portions of the substrate 8, collar 60 and pedestal 30, including a first gap 88 generally disposed between the inner circular face 74 of the collar 60 and the face 50 of the pedestal, a second gap 90 disposed between the inner annular face 72 of the collar 60 and the overhanging portion 84 of the substrate 8, and a third gap 92 disposed between the outer edge 82 of the substrate 8 and the frusto-conical face 78 of the collar 60. A non-reactive gas such as helium or argon is passed through the holes 62 into the manifold arrangement 86 and then passes through the gaps 88-92 to exit the manifold arrangement 86 adjacent the substrate edge 82. The configuration of the gaps 88-92 ensures that the gas exiting the holes 62 will substantially fill the manifold arrangement 86 before exiting through the uppermost gap 92, and that a continuous stream, or curtain, of non-reactive gas will exit gap 92 to limit access of process plasma and/or plasma cleaning media to the laminate perimeter 45.

To maximize the effectiveness of the manifold arrangement 86, the size of the gaps 88 to 92 may be adjusted by adjusting the position of the inner circular face 74, the inner annular face 72 and the frusto-conical face 78 with respect to the relative position of the circumferential wall 50, laminate perimeter 45, substrate overhanging portion 84 and edge 82, and by adjusting the gas flow rate through the holes 62. For example, during an oxygen plasma clean cycle, with a total gas flow rate through the manifold arrangement 86 of 100 sccm of argon, where the chamber pressure is 700 millitorr and the cleaning plasma forming oxygen flow rate is 300 sccm, and gaps 88 to 92 are .2 cm wide, the theoretical oxygen concentration at the laminate perimeter 45 is 39% of that present with a non-protected perimeter 45. If the gaps 90, 92 are further reduced, the theoretical amount of plasma adjacent the laminate perimeter 45 is reduced. But, if the gap 88 is reduced, the theoretical amount of oxygen or plasma adjacent the laminate perimeter 45 is increased. Reduction of the gas flow rate through the gaps 88 to 92, and the use of higher diffusivity gases in the manifold arraignment 86, will increase the concentration of reactive plasma species about the laminate perimeter 45. The gas flow enabled by the present invention substantially shields the laminate perimeter 45 from the plasma gases and thus substantially reduces the laminate perimeter 45 erosion found in the prior art. The reduction of the amount of reactive gas adjacent the laminate perimeter 45 caused by the injection of non-reactive gas at this position may also prevent any reactive gas that remains in the manifold arrangement from forming into a plasma adjacent the perimeter 45.

In addition to the masking effect of the manifold arrangement 86, the non-reactive gas passing therethrough may be used to reduce the incidence of polymer formation and contaminant deposition adjacent the perimeter 45 and other surfaces within and adjacent the manifold arrangement 86, by reducing the rate of laminate member 32 erosion and the incidence of plasma formation adjacent the laminate member 32, and by maintaining a barrier in the form of a continuous curtain of gas exiting the manifold arrangement 86 to prevent the entry of etch created polymer, and other particulate contaminants, into the area adjacent the perimeter 45 of the laminate member 32. When polymer, or another contaminant, contacts and adheres to the substrate, it contaminates the substrate 8 and reduces the die yield therefrom. By maintaining a continuous upwardly flowing barrier of gas about the laminate perimeter 45 of the laminate member 32, polymer or other contaminants which would otherwise collect in that location will be moved into the chamber 10 where a portion thereof will be flushed out of the chamber exhaust 24. The reduction, or elimination, of polymer or other contaminants in the areas adjacent the perimeter 45 of laminate member 32 will reduce the incidence of contamination of the substrate 8, because fewer polymer particles or other contaminants will be available to attach to a substrate 8. Additionally, where the gas passing through the manifold arrangement 86 does not form a plasma within the area of the gaps 88-92, polymer will not form within the manifold arrangement 86.

Referring to Figures 3 and 4, the preferred means for providing the non-reactive gas to the manifold arrangement 86 is shown. The pedestal 30 is provided with an annular gas channel 91, which extends circumferentially within the body of the pedestal 30 below the gas injection holes 62. The channel 91 is preferably formed by cutting a circumferential groove 93 in the underside of the pedestal 30, and welding, press fitting or otherwise attaching a cover 95 in the base of the groove 93. Each of the plurality of holes 62 extend from the inner terminus of the groove 93 and upwardly through the collar ledge 52 adjacent wall 50 to supply the purge gas to the manifold arrangement 86. Further, as shown in Figure 4, each hole 62 preferably includes a precision bore portion 97 which extends through the collar ledge 52, and an enlarged counterbore 99 which extends from the channel 91 to the precision bore 97 to ensure the supply of a continuous source of gas into the precision bore portions 97. Referring to Figure 3, to provide gas to the channel 91, a crossbore 111 is preferably formed from the pedestal outer diameter 54 through the channel 91 to terminate inwardly of the pedestal 30. A supply bore 113 is formed in the pedestal 30 at the inner end of the crossbore 111, and a gas feed line 115 extends from the crossbore 111 to a gas supply. The end of the crossbore 111 extending through the outer diameter 54 of the pedestal 30 is filled with a plug 117.

Although the described preferred embodiment incorporates much of the masking gas protective system within the pedestal 30, this is not essential. For example, the gas injection holes 62 could be provided elsewhere, *e.g.*, as apertures within a separate gas manifold member mounted to the chamber wall and positioned about the periphery of the pedestal. Such a separate manifold member could also define the manifold passageway gaps for channelling the injected gas over the exposed periphery of the laminate member 32. Further, although the preferred embodiment has been described with respect to an organic dielectric material formed into a laminated sheet, the advantages of the manifold arraignment 86 are also well suited to protecting other insulative or dielectric configurations and different types of insulators and dielectric materials, including inorganic materials such as quartz or SiO₂ which are eroded in plasma environments such as CHF₃ and CF₄.

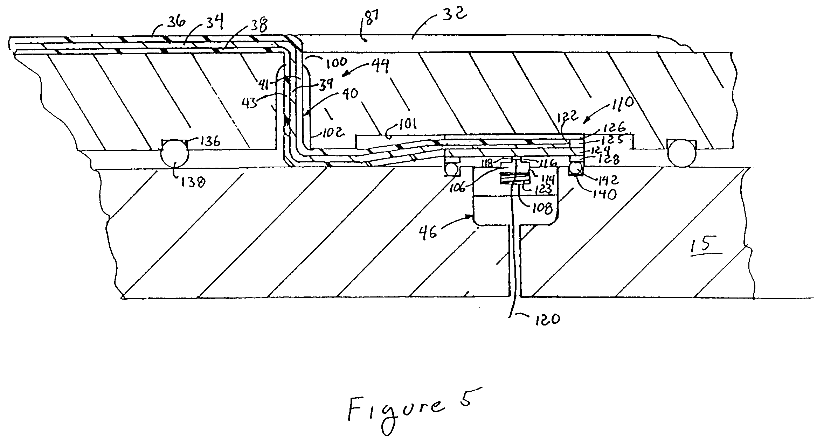

In addition to the protection provided by gas manifold arrangement 86, the erosion of the conducting strap 40 may be eliminated by extending the strap 40 directly through the pedestal 30, rather than over the pedestal edge. Referring now to Figures 2 and 5, the conductive strap 40 extends from the terminus of one of the slots 87 at the upper surface 42 of the pedestal 30 through an aperture 44 therein, and terminates in a strap end 122 which connects to a high voltage pickup 46 on the underside of the pedestal 30. The strap 40 is a continuation of the laminate member 32, and includes a central conductive core 39 formed as an extension of the electrode 34 of the laminate member 32, sandwiched between first and second dielectric layers 41, 43, formed as extensions of the upper and lower dielectric layers 36, 38 of the laminate member 32. The aperture 44 in the pedestal 32 includes a slot portion 100 extending through the laminate receiving portion 48 of the pedestal 30, and an enlarged counterbore 102 extending upwardly from the underside of pedestal 30 and intersecting the slot portion 100 below the upper surface of the pedestal. The strap 40 extends from the laminate member 32, through the slot 100 and bore 102 to terminate in contact with the high voltage pickup 46. The slot 100 is sized to receive the strap 40 therethrough with minimal clearance, to limit gas leakage through the slot 100. The strap 40 extends along the underside of the pedestal 30 and into contact with the pickup 46. The pickup 46 is provided to supply the high voltage to the laminate electrode 34.

The pickup 46 is received at the interface of the cathode 15 and pedestal 30, and is configured to form an electrical contact with the strap 40. The pickup 46 includes a spring-loaded pin member 106 received in a pickup bore 108 located in an insulated fitting received in the cathode 15, and a contact assembly 110 provided on the underside of the pedestal 30 in a recess 101. The pin member 106 is a generally right circular insulative member, which includes a first major diameter portion 114 and a second, upwardly projecting minor diameter portion 116 which terminates in a conductive terminal 118, preferably gold-plated copper. A lead 120, connected to the switchable high voltage power source 28 (Figure 1) extends through the pin member 106 to contact the terminal 118. A spring 123 is received in the bore 108 and engages the underside of the pin member 106 to bias the pin member 106 upwardly into contact with the contact assembly 110.

The contact assembly 110 is configured to receive the end 122 of the strap 40 therein to form an electrical circuit path from the pin member 106 to the strap 40. The strap 40 extends through the bore 102 and into the recess 101, and the second dielectric layer 43 of the strap 40 is removed inwardly of the end 122 of the strap 40 to expose the conductive core 39. The exposed portion of the conductive core 39 of the strap 40 is received in the contact assembly 110, which is a laminated member having a conductive disk 124, an upper insulative disk 126, a slotted disk 125 and a lower washer 128 with a central aperture 130 therethrough. The portion of the core 39 exposed adjacent the end 122 of strap 40, along with the remaining insulative layer 41, are inserted into a slot in the slotted disk 125, and the exposed portion of the core 39 and the slotted disk 125 are connected to the conductive disk 124, such as with a conductive adhesive. The conductive disk 124 may include an outer insulative annular portion, or may be a solid conductive disk. The conductive disk 124, strap end 122 and slotted disk 125 are laminated between the insulative disk 126 and the washer 128. The insulative disk 126 of the laminated contact assembly 110 is attached to the underside of the pedestal 30 within the recess 101. When the pedestal 30 is located over the cathode 15, the spring loaded pin 106 is biased into contact with the disk 124 througn the central aperture 130 in the lower washer 128, to provide high voltage from the direct current source 28 (Figure 1) to the electrode 34.

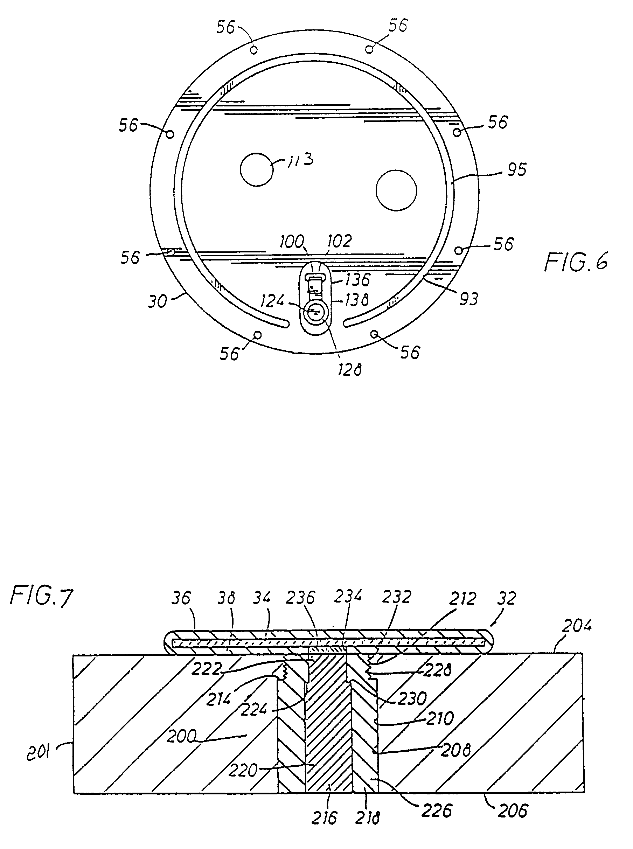

The interface of pedestal 30 and cathode 15 is sealed to prevent leakage of any cooling gas which may pass from slot 87 and through aperture 44 from passing between the pedestal 30 and the cathode 15 and into the enclosure 16. As shown in Figures 5 and 6, an ovoid seal ring groove 136 is provided about the perimeter of both the contact assembly 110 and the bore 102 in the underside of the pedestal 30, and a seal 138 is received therein. As shown only in Figure 5, a seal groove 140, which aligns with the body of the lower washer 128, is provided in the cathode 15 and a seal 142 is received therein and in contact with the lower washer 128. The seals 138, 142 are preferably o-ring seals.

By extending the lead for the electrode 34 through the body of the pedestal 30, the incidence of strap erosion that occurs where the strap extends around the edge of the pedestal and is exposed to the plasma is completely eliminated, yielding a substantial increase in the useful life of the laminate member 32.

Referring now to Figure 7, an alternative embodiment of the electrostatic chuck assembly of the present invention is shown, in which the strap 40 is completely eliminated and the pedestal is modified to receive a conductive plug assembly 200 therethrough. The modified pedestal 201 is a generally right circular conductive member having a circular top 204, a circular base 206 and a central bore 208 extending therethrough from the top 204 to the base 206. The bore 208 includes a lower, major diameter portion 210 extending inwardly of the base 206 and terminating within the modified pedestal 201, and a upper, minor diameter portion 212 extending from the terminus of the major diameter portion 208 within the modified pedestal 201 to the top 204. An annular ledge 214 is disposed at the intersection of the major diameter portion 210 and the minor diameter portion 212 within the modified pedestal 201. A dielectric/electrode laminate member 32 is adhered to the pedestal top 204 with an adhesive, and the center thereof is aligned with the center of the bore 208. The conductive plug assembly 200 extends through the bore 208 to provide the direct current voltage to the laminate member 32 to electrostatically adhere a substrate thereto during processing. The laminate member 32 includes central electrode 34, enclosed in upper and lower dielectric layers 36, 38 which are adhered to electrode 34 by glue layers.

The conductive plug assembly 200 is received in the bore 208, and includes an inner copper conductor 216, which is received within an insulative sleeve 218. The conductor 216 is preferably a solid copper member, which includes a lower major diameter portion 220 and an upper minor diameter portion 222, which intersect at an outwardly projecting flange 224. Insulative sleeve 218 is preferably formed from a polyimide material such as Vespel®, available from DuPont Corporation, and likewise includes a lower major diameter portion 226 an upper minor diameter portion 228, and an inwardly projecting radial alignment ledge 230, against which the flange 224 of the conductor 216 is received. A fine helical groove 232 is provided on the outer diameter of the sleeve minor diameter portion 228. The sleeve 218 is preferably press fit into the central bore 208, and an epoxy or other adhesive is preferably located at the interface of the sleeve minor diameter portion 228 and the bore minor diameter portion 212. The fine helical groove 232 increases the surface area for contact with the epoxy, and ensures an effective epoxy seal between the sleeve 218 and the bore 208. The conductor 216 is preferably press fit into the sleeve 218, with the flange 224 disposed against the ledge 230. After the sleeve 218 and the conductor 216 are fitted into the modified pedestal 201, and the epoxy has cured, the top 204 of the pedestal is ground flat to provide a clean, flat surface to receive laminate member 32.

To connect laminate member 32 to the high voltage source, the center of the lower dielectric layer 38 of the laminate member 32 is removed to form a conductor aperture 234 therethrough corresponding in size to the conductor minor diameter portion 222. A conductive adhesive disk 236, preferably a z-dielectric conductive adhesive disk, is disposed in the aperture 234, to provide a current path from the top of the conductor 216 to the electrode 34. The lower end of the conductor 216 exposed on the pedestal base 208 is connected to the direct current power source, through a conductive assembly such as spring loaded pin 106 as shown in Figure 6, or other means.

The conductive plug assembly 200 provides a leak-tight current path for the high voltage power supply to the laminate, while simultaneously providing a non-plasma exposed path. The conductive plug assembly 200 may be used in conjunction with the masking gas introduction member to provide a reduced plasma or gas concentration about the edge of the laminate member 32.

While the present invention has been described in conjunction with a plasma oxide etch chamber, the advantages of the present invention may be used in other chamber or processing environments where the processing environment limits the useful life of the electrostatic chuck through erosion of the dielectric layer thereof. Additionally, the use of the non-reactive gas to reduce the plasma concentration adjacent the exposed dielectric laminate edge may be used concurrently with, or separately from, the locating of the conductive path through the pedestal. Also, although the preferred embodiment herein has been described in terms of a dielectric\electrode laminate, other structures may be used to practice the invention. For example, the use of the masking gas introduction member is useful with any electrostatic chuck, where the upper layer of the chuck is an insulator or dielectric which protects the electrode and is subject to erosion in the plasma environment. This would include a pedestal which is isolated from the cathode to form the electrode, and includes an insulative or dielectric layer thereon for receiving the substrate.

## Claims

1. An electrostatic chuck for placement on a pedestal for receiving semiconductor substrates thereon for processing in a processing chamber, comprising:
an electrostatic member having an electrode therein received on the pedestal; and
an electrode voltage supply lead extending through the pedestal into engagement with the electrode.

2. The electrostatic chuck of claim 1, wherein said electrostatic member further includes a first dielectric layer on which the substrate is received and a second dielectric layer received on the pedestal, and said electrode is disposed between said dielectric layers.

3. The electrostatic chuck of claim 2, wherein said voltage supply lead is an integral extension of said electrostatic member.

4. The electrostatic chuck of claim 1, wherein the pedestal is received on a cathode in the processing chamber, and said voltage supply lead terminates in a contact assembly disposed at the interface of the pedestal and said cathode.

5. The electrostatic chuck of claim 4, wherein said contact assembly aligns with a cathode bore in said cathode, and a seal is provided circumferentially about the bore and in contact with said contact assembly to seal said cathode bore from the interface of said cathode and the pedestal.

6. The electrostatic chuck of claim 5, wherein the pedestal includes a through bore therethrough, and said strap extends from said electrostatic member, through said bore, and into said contact assembly.

7. The electrostatic chuck of claim 6, wherein a seal is disposed at the interface of the pedestal and said cathode about the periphery of both said cathode bore and said through bore.

8. The electrostatic chuck of claim 5, wherein said cathode bore includes a biased contact pin therein, and said contact pin engages said contact assembly.

9. The electrostatic chuck of claim 1, wherein the pedestal and said electrode are maintained at different voltages to maintain the substrate on the electrostatic chuck.

10. The electrostatic chuck of claim 6, wherein said pedestal bore includes a slot portion sized to receive said strap therethrough with minimal clearance and an enlarged counterbore extending therefrom.

11. The electrostatic chuck of claim 2, wherein said voltage supply lead is a solid conductor rigidly disposed through the pedestal.

12. The electrostatic chuck of claim 11, wherein said conductor is received in an insulative sleeve disposed through the pedestal.

13. The electrostatic chuck of claim 12, wherein an aperture extends through said lower dielectric layer, and a conductive disk is received therein in electrical contact with said conductor and said electrode.

14. A method of protecting the power connection for an electrostatic chuck from the environment in a processing chamber, comprising the steps of:
locating a pedestal in a processing chamber,
providing an electrostatic member on the pedestal;
extending a power supply strap for the electrostatic member through the pedestal.

15. The method of claim 14, further including the steps of:
providing a first bore through said pedestal conforming to the dimensions of said power supply strap; and
providing a second enlarged bore extending into the pedestal and terminating inward the pedestal in alignment with the first bore.

16. The method of claim 15, further including the steps of:
locating the pedestal on a structural member in the chamber; and
providing a power supply contact at the interface of the structural member and the pedestal.

17. The method of claim 16, wherein the power supply contact includes a spring biased contact pin in a bore in the structural member.

18. The method of claim 16, further including the steps of:
inserting the end of the strap in conductive engagement with a contact assembly; and
contacting the contact assembly with the power supply contact.

19. The method of claim 17, further including the step of sealing the bore in the structural member against the contact assembly.

20. The method of claim 17, further including the step of providing a seal member between the structural member and pedestal about both the counterbore and the power supply contact.

21. The method of claim 16, wherein the structural member is a cathode.
